# EUROPEAN PATENT APPLICATION

(11) **EP 2 192 828 A1**
(43) Date of publication of application: **02.06.2010**
(21) Application number: 08832608.7
(22) Date of filing: 18.09.2008
(51) Int. Cl.: H05K 9/00, B32B 7/02, G09F 9/00

(54) **CONDUCTIVE LAMINATE**

(30) Priority: 19.09.2007 JP 2007242795
(71) Applicant: Asahi Glass Company, Limited, Chiyoda-ku Tokyo 100-8405 (JP)
(72) Inventor: MORINO, Masayuki, Tokyo 100-8405 (JP); TAKEMOTO, Kazuya, Tokyo 100-8405 (JP); MIYAZAWA, Hideaki, Tokyo 100-8405 (JP); TOMIDA, Michihisa, Tokyo 100-8405 (JP); MORIMOTO, Tamotsu, Tokyo 100-8405 (JP); HINO, Yuichi, Tokyo 100-8405 (JP)
(74) Representative: Müller-Boré & Partner Patentanwälte
(86) International application number: PCT/JP2008/066880
(87) International publication number: WO 2009/038143

(57) **Abstract**

To provide an electroconductive laminate which has a broad transmission/reflection band and which is excellent in electrical conductivity (electromagnetic wave shielding properties), visible light transmittance, visible light antireflection properties, near infrared shielding properties and moisture resistance, and an electromagnetic wave shield for a plasma display employing such a laminate.
An electroconductive laminate 20 comprising a substrate 21 and an electroconductive film 22 formed on the substrate 21, wherein the electroconductive film 22 has a multilayer structure having a high refractive index layer (23a to 23e) and a metal layer (24a to 24d) alternately laminated in this order from the substrate side in a total number of 2n+1 layers (wherein n is an integer of from 1 to 12) and further having a hydrogenated carbon layer 25 at a position most removed from the substrate 21; the refractive index of the high refractive index layer (23a to 23e) is from 1.5 to 2.7; the hydrogenated carbon layer 25 contains carbon atoms and hydrogen atoms; and the content of hydrogen atoms in the hydrogenated carbon layer is from 9 to 50 atomic%.

## Description

### TECHNICAL FIELD

The present invention relates to an electroconductive laminate, an electromagnetic wave shielding film for a plasma display panel (hereinafter referred to as PDP) provided on the observer side of PDP and having electromagnetic wave shielding properties for shielding electromagnetic noises generated from PDP, and a filter for PDP.

### BACKGROUND ART

Electroconductive laminates having transparency are used as transparent electrodes for e.g. liquid crystal display devices, windshields for automobiles, heat mirrors, electromagnetic wave shielding window glass, etc. Further, an electroconductive laminate is used also as an electromagnetic wave shielding film for PDP. Electromagnetic waves are emitted from the front of PDP, and for the purpose of shielding the electromagnetic waves, an electromagnetic wave shielding film having an electroconductive film formed on a substrate such as a plastic film is disposed on the observer side of PDP.

For example, Patent Document 1 discloses an electromagnetic wave shield for PDP, which has, as an electroconductive film, a laminate having an oxide layer and a metal layer alternately laminated. However, conventional electromagnetic wave shields for PDP had problems in e.g. moisture resistance, wiping off of fingerprints, etc., and it was necessary to provide a plastic film of e.g. polyethylene terephthalate on the outermost surface of the electroconductive laminate via an adhesive. Therefore, in the production of an electromagnetic wave shield for PDP, there has been a problem that it takes time and labor to further laminate such a plastic film on the surface of the conductive laminate, whereby the number of process steps increases, the production becomes cumbersome, and the cost increases.

Further, a laminate is known which comprises a substrate and a transparent heat reflecting film having a low thermal emittance formed by laminating a dielectric layer and a metal layer and further laminating a hydrogenated carbon layer having a thickness of 70 nm as the outermost layer (Patent Document 2). However, such a laminate has a problem that the hydrogenated carbon layer is thick, whereby the visible light transmittance is low.
Patent Document 1: JP-A-2006-186309
Patent Document 2: JP-A-2005-271495

### DISCLOSURE OF THE INVENTION

### OBJECT TO BE ACCOMPLISHED BY THE INVENTION

In order to solve the above problems, it is an object of the present invention to provide an electroconductive laminate which has a broad transmission/reflection band and which is excellent in electrical conductivity (electromagnetic wave shielding properties), visible light transmittance, visible light antireflection properties, near infrared shielding properties and moisture resistance, and an electromagnetic wave shield for a plasma display.

### MEANS TO ACCOMPLISHE THE OBJECT

The present invention provides an electroconductive laminate comprising a substrate and an electroconductive film formed on the substrate, wherein the electroconductive film has a multilayer structure having a high refractive index layer and a metal layer alternately laminated in this order from the substrate side in a total number of 2n or 2n+1 layers (wherein n is an integer of from 1 to 12) and further having a hydrogenated carbon layer at a position most removed from the substrate; the refractive index of the high refractive index layer is from 1.5 to 2.7; the hydrogenated carbon layer contains carbon atoms and hydrogen atoms; and the content of hydrogen atoms in the hydrogenated carbon layer is from 9 to 50 atomic%.

Further, the present invention provides a process for producing an electroconductive laminate, which comprises a step of laminating, on the surface on one side of a substrate, a high refractive index layer and a metal layer alternately in this order in a total number of 2n or 2n+1 layers (wherein n is an integer of from 1 to 12), and a step of further forming a hydrogenated carbon layer at a position most removed from the substrate, wherein the step of forming a hydrogenated carbon layer is a step of carrying out sputtering by using a graphite target, or a step of forming by a chemical vapor deposition method wherein at least one source gas selected from CH₄, C₂H₂ and C₂H₄ is used.

### EFFECTS OF THE INVENTION

The electroconductive laminate of the present invention is excellent in electrical conductivity (electromagnetic wave shielding properties), visible light transmittance, visible light antireflection properties and near infrared shielding properties. Further, the electroconductive laminate of the present invention is excellent in moisture resistance and finger print resistance, whereby it is not required to protect the outermost surface of the electroconductive laminate by e.g. a plastic film.

### BRIEF DESCRIPTION OF DRAWINGS

Fig. 1 is a cross sectional view illustrating one embodiment of the electroconductive laminate of the present invention.
Fig. 2 is a cross sectional view illustrating one embodiment of the electroconductive laminate of the present invention.
Fig. 3 is a cross sectional view illustrating one embodiment of the electroconductive laminate of the present invention.
Fig. 4 is a cross sectional view illustrating one embodiment of the electroconductive laminate of the present invention.
Fig. 5 is a plan view of a sample for measuring the contact resistance in Examples in the present invention.
Fig. 6 is a schematic diagram of the equivalent circuit of the sample in Fig. 5.
Fig. 7 is a cross sectional view illustrating one embodiment of the filter for a plasma display of the present invention.

### MEANINGS OF SYMBOLS

10, 20, 30, 40, 100: Electroconductive laminate, 11, 21, 31, 41: substrate, 12, 22, 32, 42: electroconductive film, 13a to 13d, 23a to 23e, 33a to 33e, 43a to 43e: high refractive index layer, 47a to 47e: first high refractive index layer, 48a to 48e: second high refractive index layer, 14a to 14d, 24a to 24d, 34a to 34d, 44a to 44d: metal layer, 15, 25, 35, 45: hydrogenated carbon layer, 36, 46: adhesion layer, 100: electroconductive laminate, 101: electrode a, 102: electrode b, 103: electrode c, 104: electrode d, 200: filter for a plasma display, 210: electroconductive laminate, 211: substrate, 212: electroconductive film, 220: glass substrate, 230: adhesive layer, 240: near infrared absorbing adhesive layer, 250: antireflection film, 260: resin film, 270: antireflection layer

### BEST MODE FOR CARRYING OUT THE INVENTION

### (Substrate)

As the substrate in the present invention, a transparent substrate is preferred. In the present invention, "transparent" means to transmit light having a wavelength within a visible light region, and its transmittance is preferably at least 50%, more preferably at least 70%, further preferably at least 90%.

The material for the transparent substrate may, for example, be glass (including tempered glass such as air-cooled tempered glass or chemically tempered glass) or a plastic such as polyethylene terephthalate (PET), triacetyl cellulose (TAC), polycarbonate (PC) or polymethyl methacrylate (PMMA).

The thickness of the substrate is preferably from 0.01 mm to 10 mm, more preferably from 0.08 to 5 mm. In a case where the material for the substrate is glass, a preferred thickness is from 0.5 to 10 mm, and a more preferred thickness is from 1 to 5 mm. In a case where the material for the substrate is a plastic, a preferred thickness is from 0.01 to 3 mm, and a more preferred thickness is from 0.05 to 1 mm.

### (Electroconductive film)

In the present invention, the electroconductive film has a multilayer structure having a high refractive index layer and a metal layer alternately laminated in this order from the substrate side in a total number of 2n or 2n+1 layers (wherein n is an integer of from 1 to 12) and further having a hydrogenated carbon layer at a position most removed from the substrate. When the electroconductive film has such a structure, the thickness of the hydrogenated carbon layer may simply be increased instead of laminating a high refractive index layer on the surface, on the side opposite to the substrate, of the metal layer most removed from the substrate, whereby the number of laminated layers may be reduced, such being desirable from the viewpoint of simplicity in the production.

In the electroconductive film, the metal layers are provided preferably in from 2 to 8 layers, more preferably in from 2 to 6 layers. That is, in the electroconductive film, n=2 to 8 is preferred, and n=2 to 6 is more preferred. When the metal layers are at least two layers, it is possible to sufficiently lower the resistance value, and when they are at most 12 layers, it is possible to suppress an increase in the internal stress of the electroconductive laminate, and when they are at most 8 layers, it is possible to more distinctly suppress an increase in the internal stress.

In the electroconductive laminate of the present invention, the electroconductive film is preferably one wherein a high refractive index layer is laminated further on the surface of the metal layer of the 2n-th layer from the substrate side so that a total of 2n+1 layers (wherein n is an integer of from 1 to 12) are laminated and a hydrogenated carbon layer is further laminated at a position most removed from the substrate. In an electroconductive film having such a structure, the thickness of the hydrogenated carbon layer can be made thin, whereby it is possible to improve the visible light transmittance of the electroconductive laminate, such being desirable.

### (Metal layer)

The metal layer is preferably a layer containing silver. When the metal layer is a layer containing silver, it is possible to lower the sheet resistance of the entire electroconductive film. The content of silver in the metal layer is preferably at least 90 mass%, more preferably at least 94 mass%. When the content of silver is at least 90 mass%, the sheet resistance of the electroconductive film can be made low, such being desirable.

The metal layer is preferably a layer made of pure silver with a view to lowering the resistance of the electroconductive film. In the present invention, "pure silver" means that the metal layer (100 mass%) contains silver in an amount of at least 99.9 mass%.

The metal layer is preferably a layer made of a silver alloy further containing at least one member selected from gold, bismuth and palladium with a view to suppressing diffusion of silver and thus increasing moisture resistance. Particularly, a layer made of a silver alloy containing at least one metal selected from gold, bismuth and palladium is preferred. The total amount of at least one metal selected from gold, bismuth and palladium is preferably from 0. 2 to 1.5 mass% in the metal layer (100 mass%) in order to bring the resistivity of the metal layer to be at most 6.0 µΩcm.

The total thickness of all metal layers in the electroconductive film is preferably from 25 to 100 nm. The total thickness is more preferably from 25 to 80 nm, further preferably from 25 to 70 nm, particularly preferably from 30 to 60 nm. As the number of metal layers increases, the thicknesses of the respective metal layers tend to be thin, and the resistivity tends to be high. Accordingly, in order to lower the resistivity, the total thickness tends to be large.

The thickness of each metal layer in the electroconductive film is preferably from 5 to 25 nm, more preferably from 5 to 20 nm, further preferably from 5 to 17 nm, most preferably from 10 to 17 nm. The thicknesses of the respective metal layers in the electroconductive film may be all the same or may be different.

### (High refractive index layer)

The high refractive index layer in the electroconductive film contains an inorganic compound. The refractive index of the inorganic compound is preferably from 1.5 to 2.7, more preferably from 1.7 to 2.5, further preferably from 2.0 to 2.5. In the present invention, "refractive index" is the refractive index at a wavelength of 550 nm. The content of the inorganic compound in the high refractive index layer is preferably at least 90 mass%, more preferably at least 95 mass%, particularly preferably at least 99 mass%. The refractive index of the high refractive index layer in the electroconductive film is from 1.5 to 2.7, preferably from 1.7 to 2.5, more preferably from 1.9 to 2.4.

The inorganic compound in the present invention may, for example, be preferably a metal oxide, a metal nitride or a metal sulfide.

The metal oxide may be at least one member selected from the group consisting of an oxide of a single metal selected from zinc, titanium, niobium, tantalum, indium, tin, chromium, hafnium, zirconium, gallium, magnesium, etc., and a composite oxide of two or more of such metals.

The metal nitride may, for example, be at least one member selected from the group consisting of a nitride of a single metal selected from silicon, aluminum, etc., and a composite nitride of two or more of such metals.

The metal sulfide may be at least one member selected from the group consisting of a sulfide of a single metal selected from zinc, lead, cadmium, etc., and a composite sulfide of two or more of such metals. The inorganic compound contained in the high refractive index layer in the present invention is preferably a metal oxide, whereby the transmittance of visible light can be made high.

The high refractive index layer is preferably a layer containing, as the metal oxide, zinc oxide as the main component, particularly preferably a layer containing a metal oxide having a high refractive index of at least 2.3 and zinc oxide as the main components (hereinafter sometimes referred to as a zinc oxide-containing layer). The zinc oxide-containing layer preferably contains a high refractive index metal oxide having a refractive index of at least 2.3 and zinc oxide in a total content of at least 90 mass%, more preferably at least 95 mass%, particularly preferably at least 99 mass%. The high refractive index layer contains zinc oxide in an amount of preferably at least 50 mass%, more preferably from 70 to 90 mass%.

Among high refractive index metal oxides having a refractive index of at least 2.3, preferred is at least one member selected from titanium oxide (refractive index: 2.5) and niobium oxide (refractive index: 2.4), since it is thereby possible to further broaden the reflection band.

By the presence of the high refractive index metal oxide, the refractive index of the zinc oxide-containing layer can be increased, and the transmission/reflection band of the electroconductive film can be broadened. In the zinc oxide-containing layer, the content of metal atoms in the high refractive index metal oxide is preferably from 1 to 50 at%, particularly preferably from 5 to 20 at%, based on the total amount of the metal atoms and zinc atoms. Within this range, the transmission/reflection band can be maintained broad and further, an electroconductive film having good moisture resistance can be obtained. The reason is not necessarily clear but is considered to be such that the stress of the high refractive index layer and the metal layer can be released while good physical properties of zinc oxide are maintained within this range.

The high refractive index layer may contain a metal oxide other than zinc oxide, titanium oxide and niobium oxide within a range not to impair physical properties. For example, for the purpose of imparting electrical conductivity, gallium oxide, indium oxide, aluminum oxide, magnesium oxide or the like may be incorporated.

The physical film thickness (hereinafter referred to simply as the thickness) of the high refractive index layer is preferably from 20 to 60 nm (particularly from 30 to 50 nm) in the case of a high refractive index layer closest to the substrate and a high refractive index layer farthest from the substrate and is preferably from 40 to 120 nm (particularly from 40 to 100 nm) in the case of other high refractive index layers. Each high refractive index layer may be made of a single uniform layer or may be a multilayer film having two or more layers laminated.

In a case where the high refractive index layer made of a multilayer film is, for example, a double layer film having a first high refractive index layer and a second high refractive index layer laminated in this order from the substrate side, it is preferred that the first high refractive index layer contains a metal oxide such as niobium oxide or titanium oxide, and the refractive index of the entire first high refractive index layer is at least 2.3. In a case where the metal layer is a layer containing silver, the second high refractive index layer is preferably a layer containing zinc oxide as the main component, more preferably the above mentioned zinc oxide-containing layer. In such a case, it is preferred that the metal layer is laminated in direct contact with the surface, on the side opposite to the substrate, of the second high refractive index layer. A substance containing zinc oxide as the main component has its crystal structure which is close to a crystal structure of silver constituting the metal layer. Accordingly, when silver is laminated directly on the second high refractive index layer made of a material containing zinc oxide as the main component, it is possible to obtain a metal layer made of silver having high crystallinity. Silver having good crystallinity has a low resistivity, whereby the resistivity of the metal layer can be made low, and accordingly, the thickness of the metal layer to obtain the desired sheet resistance, can be made thin. By making the thickness of the metal layer thin, it is possible to increase the visible light transmittance of the electroconductive laminate, such being desirable. Further, by improving the crystallinity of silver in the metal layer, it is considered possible to reduce the migration. By making the second high refractive index layer from a material containing zinc oxide as the main component, migration of silver can be suppressed, and the adhesion between the second high refractive index layer and the metal layer can be maintained. By maintaining the adhesion, it is possible to prevent penetration of moisture to the interface, whereby the moisture resistance of silver will be good, such being desirable.

The thickness of the first high refractive index layer is preferably from 20 to 60 nm (particularly from 30 to 50 nm) with respect to the first high refractive index layer closest to the substrate, or preferably from 40 to 120 nm (particularly from 40 to 100 nm) with respect to other first high refractive index layers. The thickness of the second high refractive index layer is preferably from 1 to 20 nm, more preferably from 2 to 10 nm, further preferably from 3 to 6 nm.

The high refractive index layers in the present invention may be made of the same material to have the same construction or may be made of different materials to have different constructions. Further, also with respect to the thickness, the high refractive index layers in the present invention may have the same thickness or different thicknesses.

### (Hydrogenated carbon layer)

The hydrogenated carbon layer contains carbon atoms and hydrogen atoms, and the content of hydrogen atoms is from 9 to 50 atom% in the hydrogenated carbon layer. The content of hydrogen atoms is preferably from 15 to 50 atom%, more preferably from 20 to 48 atom%, further preferably from 25 to 45 atom%.

If the content of hydrogen atoms exceeds 50 atom%, it is likely that polymer DLC will be formed, and the mechanical durability substantially decreases. When the content of hydrogen atoms is at least 9 atom%, the visible light transmittance can be made high, such being desirable. If the content of hydrogen atoms in the hydrogenated carbon layer in the present invention becomes small, sp2 bond will increase, and an optical energy gap tends to be narrow, whereby absorption of light in a visible light region will increase. As a result, the luminous transmittance of the electroconductive laminate of the present invention tends to be low. Thus, if the content of hydrogen atoms is less than 9 atom%, the luminous transmittance of the conductive laminate of the present invention is likely to be lower than 60%. If the luminous transmittance of the electroconductive laminate of the present invention becomes lower than 60%, the degree of freedom in designing the color compensation, etc. of the entire filter tends to be less, such being undesirable, particularly in a case where the electroconductive laminate of the present invention is applied to a filter for a display, particularly to a filter for a plasma display.

The thickness of the hydrogenated carbon layer is preferably from 1 to 60 nm. In a case where the electroconductive film in the present invention is one having a high refractive index layer and a metal layer laminated alternately in this order from the substrate side in a total number of 2n layers (wherein n is an integer of from 1 to 12), the thickness of the hydrogenated carbon layer is preferably from 20 to 60 nm, more preferably from 30 to 50 nm. In such a case, the hydrogenated carbon layer has the same function as the high refractive index layer and contributes to improvement of the optical characteristics (improvement of the luminous transmittance or reduction of the visible light reflectance) of the electroconductive laminate.

Further, in a case where the electroconductive film in the present invention is one having a high refractive index layer and a metal layer laminated alternately in this order from the substrate side in a total number of 2n+1 layers (wherein n is an integer of from 1 to 12), the thickness of the hydrogenated carbon layer is preferably from 2 to 15 nm, more preferably from 3 to 10 nm. In such a case, the thickness of the hydrogenated carbon layer can be made thin. Accordingly, the visible light transmittance of the electroconductive laminate can be made high, such being desirable.

### (Adhesion layer)

For the purpose of improving the mechanical durability of the electroconductive laminate of the present invention, it is preferred to have an adhesion layer further laminated so that it is in direct contact with the substrate-side surface of the hydrogenated carbon layer. The adhesion layer is a layer made of a material which is excellent in adhesion and hardly detachable when laminated in direct contact with the hydrogenated carbon layer, the high refractive index layer or the metal layer. As the material for the adhesion layer, a film containing an oxide or nitride of a metal such as Sn, In, Ti, Si or Ga may, preferably, be mentioned. In a case where the electroconductive film in the present invention has a multilayer structure having a high refractive index layer and a metal layer alternately laminated in this order from the substrate side in a total number of 2n+1 layers and further having a hydrogenated carbon layer at position most removed from the substrate, and the high refractive index layer is a layer containing zinc oxide as the main component, the adhesion layer is more preferably a film containing an oxide of Sn. Particularly preferred is an indium/tin oxide (ITO) film or a gallium/indium/tin oxide (GIT) film.

By providing an adhesion layer on the substrate-side of the hydrogenated carbon layer, the adhesion between the adhesion layer and the hydrogenated carbon layer would be excellent, whereby the hydrogenated carbon layer is hardly peeled, and the mechanical durability of the electroconductive laminate thereby obtained will be excellent. Further, by providing such an adhesion layer, it is also possible to obtain such an effect that the chemical resistance of the electroconductive laminate of the present invention is improved. Further, the adhesion layer prevents moisture from permeating, whereby it is possible to prevent diffusion or penetration of moisture to the high refractive index layer or metal layer of the electroconductive laminate, and thus the moisture resistance of the electroconductive laminate will be improved, such being desirable. That is, by providing such an adhesion layer, the time constant in diffusion of moisture in the electroconductive laminate will be increased, such being desirable.

The thickness of the adhesion layer is preferably from 2 to 30 nm, more preferably from 3 to 20 nm.

### (Other layers)

In the electroconductive film in the present invention, other layers may be inserted within a range not to impair the functions of the electroconductive film. The materials to be used for such other layers may, for example, be organic compounds or inorganic compounds having a refractive index of less than 1.5 or more than 2.5.

### (Method for producing electroconductive laminate)

A method of forming an electroconductive film may, for example, be sputtering, vacuum deposition, ion plating or chemical vapor deposition, and sputtering is particularly preferred in view of good stability of quality and properties. The sputtering may, for example, be pulse sputtering or AC sputtering.

Particularly, as a method of forming a hydrogenated carbon layer, AC sputtering or chemical vapor deposition may preferably be mentioned. In AC sputtering, the direction of electrical current periodically changes, whereby an electrical charge is less likely to be stored in the object to be treated, whereby it is possible to prevent formation of defects in a film by arcing during the film deposition. Further, AC sputtering is preferred, since a highly compact film is formed by a plasma stream present in the vicinity of the object to be treated.

Chemical vapor deposition may, for example, be magnetron plasma CVD or LIS (Linear Ion Source)-CVD.

In magnetron plasma CVD, a cathode (such as a carbon target) and an object to be treated, are disposed in a chamber, and radio frequency (13.56 MHz or 27.12 MHz) is applied to the cathode, whereby the cathode is negatively biased to generate a plasma. And, a source gas (at least one type of gas selected from CH₄, C₂H₂ and C₂H₄) is simultaneously supplied, whereby such a gas is decomposed by the plasma to deposit a hydrogenated carbon layer on the surface of the object to be treated. In such a case, by incorporating a magnet such as a magnetic circuit to the cathode, magnetic field lines are generated, and such magnetic field lines will reach the surface of the object to be treated. By electrons captured by magnetic flux, magnetron discharge will take place in the vicinity of the surface of the object to be treated, whereby the film-deposition rate will be increased. Such magnetic field lines are preferably from 100 G to 1,000 G, more preferably from 300 G to 500 G. When the magnetic field lines are at least 100 G, the film deposition rate can be sufficiently increased, such being desirable. Further, when the magnetic field lines are at most 1,000 G, the plasma may not be too strong, and damages of the object to be treated by heat are less likely to take place, such being desirable.

LIS-CVD is a method of forming a hydrogenated carbon layer by introducing a source gas (at least one type of gas selected from CH₄, C₂H₂ and C₂H₄) to LIS. LIS is an abbreviation of Linear Ion Source. An anode and a cathode are disposed, and by applying a DC bias between the anode and the cathode, a plasma is generated. The source gas is introduced thereto, whereby the source gas is decomposed to deposit a hydrogenated carbon layer on the surface of the high refractive index layer. In LIS-CVD, an ion beam is employed, whereby a dense hydrogenated carbon layer can be formed, and a film excellent in mechanical strength can be formed, such being desirable.

Formation of an electroconductive film by sputtering may, for example, be carried out as follows. The following method is merely an example of the method for producing an electroconductive laminate of the present invention, and the present invention is by no means thereby restricted.
(i) A high refractive index layer is formed on the surface of a substrate by carrying out pulse sputtering by using a target containing a metal oxide, while introducing a gas prepared by mixing oxygen gas and argon gas.
(ii) A metal layer is formed by carrying out pulse sputtering by using a silver target or silver alloy target, while introducing argon gas.
(iii) The above operations (i) and (ii) are repeated in a total of n times, and finally, a high refractive index layer is formed by the same operation as (i).
(iv) A hydrogenated carbon layer is formed on the surface of the finally formed high refractive index layer by carrying out pulse sputtering by using a graphite target, while introducing a gas prepared by mixing hydrogen gas and argon gas.

In the above (iv), the hydrogen gas content in the gas prepared by mixing hydrogen gas and argon gas is preferably from 5 to 60 vol%, more preferably from 15 to 40 vol%. Within such a range, the hydrogen atom content in the obtainable hydrogenated carbon layer can be made to be a desired content, such being desirable.

The material for the target to form the above high refractive index layer may, for example, be at least one member selected from the group consisting of a metal oxide of each of zinc, titanium, niobium, tantalum, indium, tin, chromium, hafnium, zirconium, gallium and magnesium, and a composite oxide of two or more of such metals. Particularly preferred is a target containing a metal oxide having a high refractive index of at least 2.3 and zinc oxide as the main components (hereinafter referred to as a zinc oxide-containing target). Such a zinc oxide-containing target contains a high refractive index metal oxide having a refractive index of at least 2.3 and zinc oxide in a total amount of preferably at least 90 mass%, more preferably at least 95 mass%, particularly preferably at least 99 mass%.

Among high refractive index metal oxides having refractive indices of at least 2.3, at least one member selected from titanium oxide (refractive index: 2.5) and niobium oxide (refractive index: 2.4) is preferred, since it is thereby possible to further broaden the reflection band.

Further, as the target, it is possible to employ a target made of at least one metal selected from silicon, aluminum, zinc, lead and cadmium. In such a case, a higher refractive index layer can be formed by carrying out reactive sputtering by introducing oxygen gas in addition to argon gas.

In the above production method, with respect to the step (iv) of forming a hydrogenated carbon layer, the following methods (iv)-2 and (iv)-3 may also be mentioned.

### (iv)-2

A hydrogenated carbon layer is formed by magnetron plasma CVD. Specifically, the method is carried out, for example, as follows. Radio frequency (13.56 MHz or 27.12 MHz) is applied to a cathode, whereby the cathode is negatively biased to generate a plasma. And, by supplying a source gas (at least one type of gas selected from CH₄, C₂H₂ and C₂H₄) simultaneously, such a gas is decomposed by the plasma to form a hydrogenated carbon layer on the surface of the high refractive index layer. In such a case, by incorporating a magnet such a magnetic circuit to the cathode, magnetic field lines are generated.

### (iv)-3

A hydrogenated carbon layer is formed by LIS-CVD. Specifically, the method is carried out, for example, as follows. A direct current voltage of 1 kV (DC) is applied to an anode, and 50 sccm of a source gas (at least one type of gas selected from CH₄, C₂H₂ and C₂H₄) is supplied simultaneously in LIS, whereby such a gas is decomposed by plasma to form a hydrogenated carbon layer on the surface of the high refractive index layer.

### (Electroconductive laminate)

The electroconductive laminate of the present invention will be described with reference fo the drawings, but it should be understood that the present invention is by no means thereby restricted.

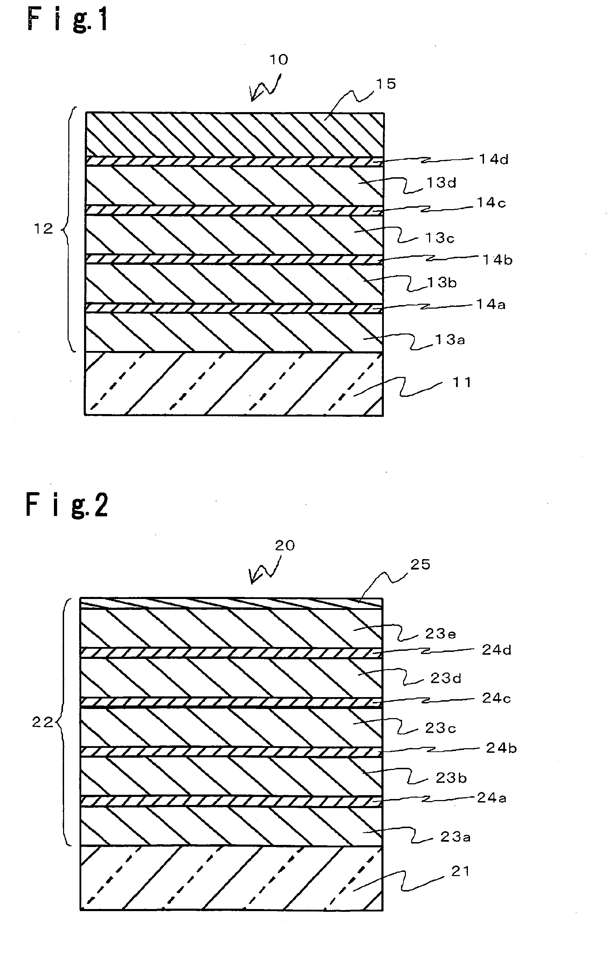

Fig. 1 is a schematic cross sectional view illustrating one embodiment of the electroconductive laminate of the present invention wherein an electroconductive film has a high refractive index layer and a metal layer alternately laminated in this order from the substrate side in a total number of 2n layers. The electroconductive laminate 10 comprises a substrate 11 and an electroconductive film 12 formed on the substrate 11. The electroconductive film 12 is a laminate comprising, sequentially from the substrate 11 side, a high refractive index layer 13a / a metal layer 14a / a high refractive index layer 13b / a metal layer 14b / a high refractive index layer 13c / a metal layer 14c / a high refractive index layer 13d / a metal layer 14d / a hydrogenated carbon layer 15. Fig. 1 illustrates a case where n=4. However, also in a case where n= other than 4, an electrical conductive laminate wherein n is different, can be produced by optionally changing the number of lamination times of the high refractive index layer and the metal layer.

Fig. 2 is a schematic cross sectional view illustrating one embodiment of the electroconductive laminate of the present invention wherein the electroconductive film has a high refractive index layer and a metal layer laminated alternately in this order from the substrate side in a total number of 2n+1 layers. The electrical conductive laminate 20 comprises a substrate 21 and an electroconductive film 22 formed on the substrate 21. The electroconductive film 22 is a laminate comprising, sequentially from the substrate 21 side, a high refractive index layer 23a / a metal layer 24a / a high refractive index layer 23b / a metal layer 24b / a high refractive index layer 23c / a metal layer 24c / a high refractive index layer 23d / a metal layer 24d / a high refractive index layer 23e / a hydrogenated carbon layer 25. In this case, the thickness of the high refractive index layer 23a closest to the substrate and the thickness of the high refractive index layer 23e most removed from the substrate, are preferably from 20 to 60 nm (particularly from 30 to 50 nm). By such a construction, it is possible to obtain an electroconductive laminate which is not only excellent in the moisture resistance but also excellent in optical characteristics. Here, the optical characteristics mean that the visible light transmittance can be made high, the visible light reflectance can be made low, and reflection of visible light can be suppressed at a low level in a wide wavelength region.

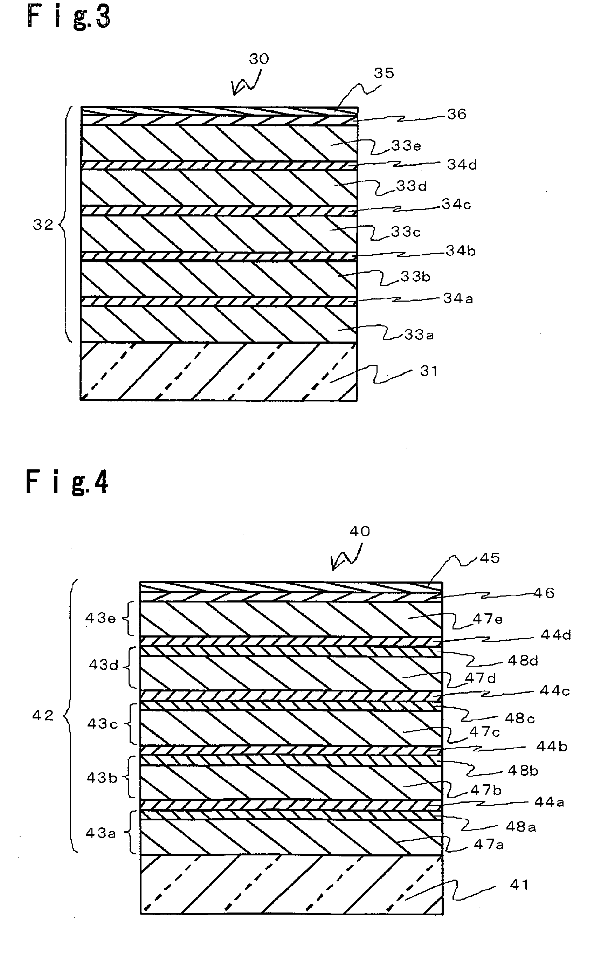

Fig. 3 is a schematic cross sectional view illustrating one embodiment of the electroconductive laminate of the present invention wherein the electroconductive film has a high refractive index layer and a metal layer laminated alternately in this order from the substrate side in a total number of 2n+1 layers, and an adhesion layer is further provided. The electroconductive laminate 30 comprises a substrate 31 and an electroconductive film 32 formed on the substrate 31. The electroconductive film 32 is a laminate comprising, sequentially from the substrate 31 side, a high refractive index layer 33a / a metal layer 34a/ a high refractive index layer 33b / a metal layer 34b / a high refractive index layer 33c / a metal layer 34c / a high refractive index layer 33d / a metal layer 34d / a high refractive index layer 33e / an adhesion layer 36 / a hydrogenated carbon layer 35. In this construction, as compared with the construction in Fig. 2, the adhesion layer 36 is further added. By providing the adhesion layer 36, the electroconductive laminate 30 can be made one superior in mechanical durability, moisture resistance and chemical resistance.

Fig. 4 is a schematic cross sectional view illustrating one embodiment of the electroconductive laminate of the present invention wherein the electroconductive film has a high refractive index layer and a metal layer laminated alternately in this order from the substrate side in a total number of 2n+1 layers, each of the 1 st to n-th high refractive index layers from the substrate is made of two layers, the n+1 th high refractive index layer is made of a single layer, and an adhesion layer is further provided. The electroconductive laminate 40 comprises a substrate 41 and an electroconductive film 42 formed on the substrate 41. The electroconductive film 42 is a laminate comprising, sequentially from the substrate 41 side, a first high refractive index layer 47a / a second high refractive index layer 48a / a metal layer 44a / a first high refractive index layer 47b / a second high refractive index layer 48b / a metal layer 44b / a first high refractive index layer 47c / a second high refractive index layer 48c / a metal layer 44c / a first high refractive index layer 47d / a second high refractive index layer 48d / a metal layer 44d / a first high refractive index layer 47e / an adhesion layer 46 / a hydrogenated carbon layer 45.

The electroconductive laminate of the present invention is preferably one having a luminous transmittance of at least 60%, more preferably one having a luminous transmittance of at least 65%. In a case where the electroconductive laminate of the present invention is to be used for a filter for PDP, it is necessary to further carry out color compensation by using e.g. a colorant to absorb a visible light region for the color design of the entire PDP filter. To carry out the color compensation, it is necessary to make the luminous transmittance of the filter for PDP sufficiently high before the color compensation, whereby it is possible to avoid a possibility that the luminous transmittance of the filter for PDP becomes too low by the addition of the colorant for the color compensation. In order to broaden the degree of freedom for the color compensation of the filter for PDP, the higher the luminous transmittance of the electroconductive laminate of the present invention, the better. And it is preferred to bring the luminous transmittance of the electroconductive laminate of the present invention to be at least 60%, whereby the degree of freedom for the color compensation of the filter for PDP can sufficiently be secured. It is more preferred to bring the luminous transmittance to be at least 65%, whereby the degree of freedom for the color design of the entire filter can further be increased.

Further, the electroconductive laminate of the present invention is preferably one having a transmittance at a wavelength of 850 nm being at most 5%, particularly preferably at most 2%.

The resistance of the electroconductive laminate of the present invention is preferably from 0.4 to 3.5 Ω/□, more preferably from 0.6 to 2.5 Ω/□, further preferably from 0.7 to 1.5 Ω/□. When the resistance is within such a range, the electromagnetic wave shielding properties and the visible light transmittance can sufficiently be secured.

Further, the contact resistance at the surface of the electroconductive film in the electroconductive laminate of the present invention is preferably from 0.25 to 0.6 Ω, more preferably from 0.3 to 0.5 Ω. When the contact resistance is at most 0.6 Ω, the decrease in the electromagnetic wave shielding performance of the electroconductive laminate of the present invention by the contact resistance can be made to be not more than 4 dB. The lower the contact resistance, the better. However, from the technical limit, the lower limit is preferably 0.25 Ω.

### (Use)

The electroconductive laminate of the present invention is excellent in electrical conductivity (electromagnetic wave shielding properties), visible light transmittance and near infrared shielding properties, and yet, when it is laminated on a supporting substrate of e.g. glass, the transmission/reflection band will be broadened, and thus, it is useful as an electromagnetic wave shield for PDP.

Further, the filter for PDP of the present invention has the above mentioned electromagnetic wave shield for PDP and further may contain a layer having another function. The layer having another function may, for example, be an antireflection layer against visible light, a color compensation layer, a near infrared absorbing layer or a hard coating layer .

The electromagnetic wave shield for PDP of the present invention has a hydrogenated carbon layer laminated on the outermost surface, whereby it is excellent in moisture resistance and fingerprint resistance. Accordingly, in the filter for PDP having such an electromagnetic wave shield for PDP, it is not required to bond a plastic film such as a PET film on the surface of the electroconductive film in order to protect the electroconductive laminate from e.g. moisture, whereby it is possible to reduce the number of film lamination times. It is thereby possible to reduce the labor and thus to reduce the cost in the production of the filter for PDP.

Now, one embodiment of the filter for PDP of the present invention will be described with reference to the drawing, but it should be understood that the present invention is by no means restricted thereto.

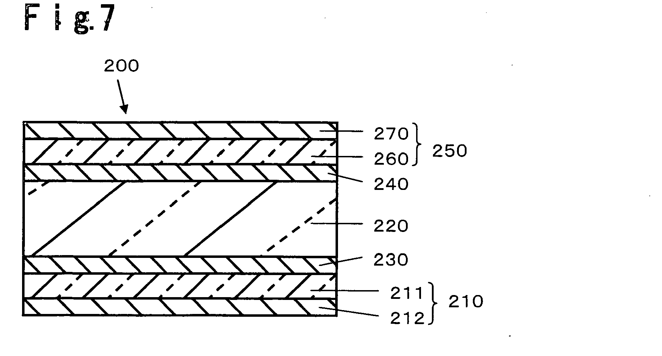

In Fig. 7, an electroconductive laminate 210 is disposed, via an adhesive layer 230, on one surface of a glass substrate 220. The electroconductive laminate 210 is disposed so that a substrate 211 faces the glass substrate 220. On the other surface of the glass substrate 220, an antireflection film 250 comprising a resin film 260 and an antireflection layer 270, is disposed via a near infrared-absorbing adhesive layer 240 made of an adhesive containing a near infrared-absorbing colorant. The antireflection film 250 is disposed so that the resin film 260 faces the glass substrate 220. As the resin film 260, one made of the same material and having the same thickness as the substrate 211 may be used. The antireflection layer 270 may, for example, be a laminate having a thin film of a high refractive index material and a thin film of a low refractive index material alternately laminated, or a layer made of a low refractive index material. The layer made of a low refractive index material may, for example, be a layer made of a fluororesin such as a fluorinated acrylic resin or a layer of a compound containing a silicon atom. This filter for PDP is disposed on the observer's side of PDP so that the electroconductive laminate 210 faces PDP.

In the electroconductive laminate 210 of the present invention, a hydrogenated carbon layer is disposed at a position most removed from the substrate 211 i.e. at the outermost surface, whereby it is possible to prevent e.g. migration of silver in the electroconductive laminate by e.g. moisture, even though a protective film such as a resin film is not further provided on the surface of the electroconductive film 212.

The electroconductive laminate of the present invention is capable of taking electrical conduction between the conductive film surface and an earth component such as an electrode or a gasket. Accordingly, with a filter for PDP having an electrical conductive film 212 disposed on the outermost surface as shown in Fig. 7, it is possible to simply take electrical conduction with the main body of the PDP apparatus for earth connection.

Further, the electroconductive laminate of the present invention can be used as a transparent electrode for e.g. a liquid crystal display device. Such a transparent electrode has a low surface resistance and is thereby well responsive, and is capable of suppressing the reflectance, whereby the visibility will be good.

Further, the electroconductive laminate of the present invention can be used as a windshield for an automobile. Such a windshield for an automobile exhibits a function to prevent fogging or to melt ice by applying a current to the electroconductive film, the voltage required to apply the current is low since it has a low resistance, and the reflectance can be suppressed so that the visibility of a driver will not be impaired.

Further, the electroconductive laminate of the present invention, which has a very high reflectance in the infrared region, can be used as a heat mirror to be provided on e.g. a window of a building.

Further, the electroconductive laminate of the present invention, which has a high electromagnetic wave shielding effect, can be used for an electromagnetic wave shielding window glass which prevents electromagnetic waves emitted from electrical or electronic equipment from leaking out of the room, or which prevents electromagnetic waves affecting electrical or electronic equipment from entering into the room from the outside.

### EXAMPLES

Now, the present invention will be described in detail with reference to Examples, but it should be understood that the present invention is by no means thereby restricted.

Examples 1 and 3 to 8 are working examples of the present invention, and Example 2 is a comparative example.

### (Measurement of hydrogen atom content in hydrogenated carbon layer)

The hydrogen concentration in a hydrogenated carbon layer was measured by using a scanning Auger electron spectroscopic analyzer (product name: PHI4300 model modified, manufactured by Perkin-Elmer) and an electrostatic hemispherical detector (EA125, manufactured by Omicron).

### (Moist heat resistance test)

An electroconductive laminate was cut into a size of 100 mm x 100 mm, and for the purpose of stabilizing the shape, its substrate side was bonded to a soda lime glass plate of 100 mm x 100 mm with a thickness of 1.8 mm via an adhesive layer. Such an electroconductive laminate-bonded glass plate was maintained in a constant temperature and moisture tank (product name: IG420, manufactured by Yamato Scientific Co., Ltd.) at a temperature of 60°C under a humidity of 90%RH for 500 hours, and after taking it out, the number of defects on the surface of the electroconductive laminate 10 was counted.

### (Measurement of luminous transmittance)

With respect to an electroconductive laminate, the luminous transmittance (stimulus Y stipulated in JIS Z 8701) was measured by a color analyzer (product name: TC1800, manufactured by Tokyo Denshoku Co., Ltd.).

### (Mechanical durability test)

An electroconductive laminate was cut into a size of 100 mm x 100 mm, and for the purpose of stabilizing the shape, its substrate side was bonded to a soda lime glass of 100 mm x 100 mm with a thickness of 1.8 mm via an adhesive layer. The electroconductive laminate-side surface of this glass plate was rubbed 200 times in one direction on the surface at a rate of 17 reciprocations per minute with white cotton flannel while exerting a load of 500 g by a flat surface rubbing tester (product name:
No. 821, manufactured by Coating Tester Kogyo K.K.). The widths of scratch marks imparted to the electroconductive laminate bonded to this glass plate were measured. (Contact resistance test)

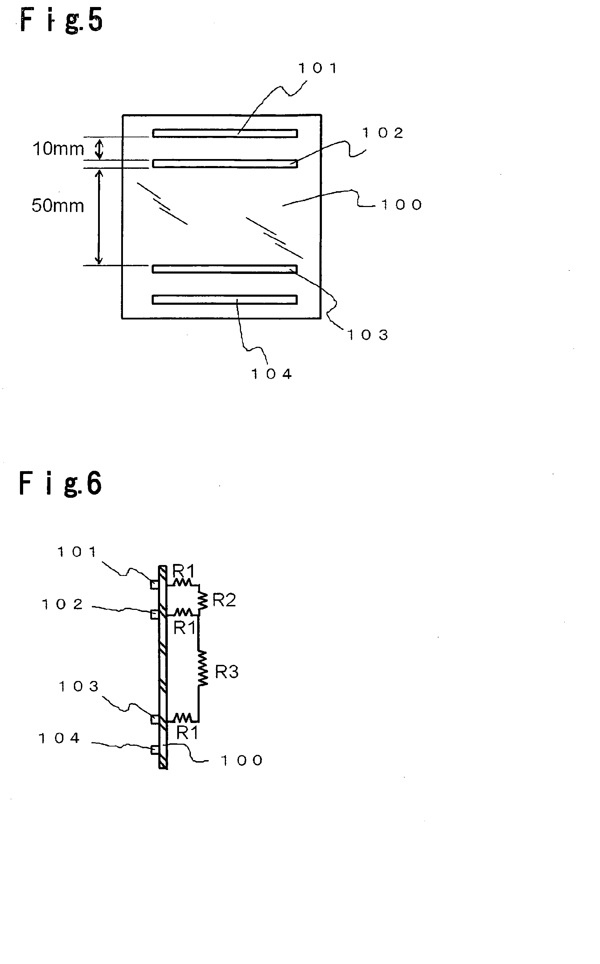

An electroconductive laminate was cut into a size of 100 mm x 100 mm, and for the purpose of stabilizing the shape, its substrate 11 side was bonded to a soda lime glass plate of 100 mm x 100 mm with a thickness of 1.8 mm via an adhesive layer. A silver paste (tradename: AF4810, manufactured by TAIYO INK MFG. CO., LTD.) was screen-printed in a shape as shown in Fig. 5 on the surface of the electroconductive laminate bonded to this glass plate and dried at 85°C for 35 minutes in a hot air circulating furnace to form an electrode a101, an electrode b102, an electrode c103 and an electrode d104.

Then, the electrical resistance R(a-b) between the electrode a101 and the electrode b in Fig. 5 was measured. Further, the electrical resistance R(b-c) between the electrode b and the electrode c was measured. In Fig. 5, when the contact resistance between the electrode (silver paste) and the laminate is designated as R1, the resistance of the electroconductive laminate between the electrodes a and b is designated as R2, and the resistance of the electroconductive laminate between the electrodes b and c is designated as R3, a relation of R3=5R2 is established from the distances between the electrodes. From the foregoing, R1 can be calculated by R1={5R(a-b)-R(b-c)}/8. By using this relational expression, the contact resistance between the electroconductive laminate and the silver paste was calculated.

### EXAMPLE 1

An electroconductive laminate 30 shown in Fig. 3 was prepared as follows.

First, dry cleaning by ion beams was carried out as follows for the purpose of cleaning the surface of a PET film with a thickness of 100 µm as a substrate 31. First, about 30% of oxygen was mixed with an argon gas, and an electric power of 100 W was charged. Argon ions and oxygen ions ionized by an ion beam source were applied to the surface of the substrate.

Then, on the surface of the substrate to which the dry cleaning treatment was applied, pulse sputtering was carried out using a mixed target of zinc oxide and titanium oxide (zinc oxide:titanium oxide = 80:20 (mass ratio)) by introducing a gas mixture of an argon gas and 10 vol% of an oxygen gas under a pressure of 0.73 Pa at a frequency of 50 kHz at an electric power density of 4.5 W/cm² at a reverse pulse duration of 2 µsec to form a high refractive index layer 32a with a thickness of 35 nm and a refractive index of 2.1. As measured by Rutherford backscattering spectrometry, in the high refractive index layer 33a, zinc occupied 80 at% and titanium occupied 20 at% based on the total amount (100 at%) of zinc and titanium. Further, in the high refractive index layer 33a, zinc occupied 34.3 at%, titanium occupied 8.0 at% and oxygen occupied 57.7 at% based on all atoms (100 at%). Converted to ZnO and TiO₂, the total amount of oxides was 96.7 mass%.

Then, pulse sputtering was carried out using a silver alloy target doped with 1.0 mass% of gold by introducing an argon gas under a pressure of 0.73 Pa at a frequency of 50 kHz at an electric power density of 2.3 W/cm² with a reverse pulse duration of 10 µsec to form a metal layer 34a with a thickness of 9 nm.

Then, pulse sputtering was carried out by using a mixed target of zinc oxide and titanium oxide (zinc oxide:titanium oxide = 80:20 (mass ratio)) by introducing a gas mixture of an argon gas and 10 vol% of an oxygen gas under a pressure of 0.73 Pa at a frequency of 50 kHz at an electric power density of 4.5 W/cm² with a reverse pulse duration of 2 µsec to form a zinc oxide/titanium oxide mixed film (refractive index: 2.1) with a thickness of 70 nm. A high refractive index layer 33b was formed by the zinc oxide/titanium oxide mixed film thus obtained.

Then, pulse sputtering was carried out using a silver alloy target doped with 1.0 mass% of gold by introducing an argon gas under a pressure of 0.73 Pa at a frequency of 50 kHz at an electric power density of 2.3 W/cm² with a reverse pulse duration of 10 µsec to form a metal layer 34b with a thickness of 11 nm.

Then, pulse sputtering was carried out by using a mixed target of zinc oxide and titanium oxide (zinc oxide:titanium oxide = 80:20 (mass ratio)) by introducing a gas mixture of an argon gas and 10 vol% of an oxygen gas under a pressure of 0.73 Pa at a frequency of 50 kHz at an electric power density of 4.5 W/cm² with a reverse pulse duration of 2 µsec to form a zinc oxide/titanium oxide mixed film (refractive index: 2.1) with a thickness of 70 nm. A high refractive index layer 33c was formed by the zinc oxide/titanium oxide mixed film thus obtained.

Then, pulse sputtering was carried out using a silver alloy target doped with 1.0 mass% of gold by introducing an argon gas under a pressure of 0.73 Pa at a frequency of 50 kHz at an electric power density of 2.3 W/cm² with a reverse pulse duration of 10 µsec to form a metal layer 34c with a thickness of 14 nm.

Then, pulse sputtering was carried out by using a mixed target of zinc oxide and titanium oxide (zinc oxide:titanium oxide = 80:20 (mass ratio)) by introducing a gas mixture of an argon gas and 10 vol% of an oxygen gas under a pressure of 0.73 Pa at a frequency of 50 kHz at an electric power density of 4.5 W/cm² with a reverse pulse duration of 2 µsec to form a zinc oxide/titanium oxide mixed film (refractive index: 2.1) with a thickness of 70 nm. A high refractive index layer 33d was formed by the zinc oxide/titanium oxide mixed film thus obtained.

Then, pulse sputtering was carried out using a silver alloy target doped with 1.0 mass% of gold by introducing an argon gas under a pressure of 0.73 Pa at a frequency of 50 kHz at an electric power density of 2.3 W/cm² with a reverse pulse duration of 10 µsec to form a metal layer 34d with a thickness of 14 nm.

Then, pulse sputtering was carried out by using a mixed target of zinc oxide and titanium oxide (zinc oxide:titanium oxide = 80:20 (mass ratio)) by introducing a gas mixture of an argon gas and 10 vol% of an oxygen gas under a pressure of 0.73 Pa at a frequency of 50 kHz at an electric power density of 4.5 W/cm² with a reverse pulse duration of 2 µsec to form a zinc oxide/titanium oxide mixed film (refractive index: 2.1) with a thickness of 30 nm. A high refractive index layer 33e was formed by the zinc oxide/titanium oxide mixed film thus obtained.

Then, pulse sputtering was carried out by using a mixed target of gallium oxide, indium oxide and tin oxide (GIT target; manufactured by AGC Ceramics Co., Ltd.) by introducing a gas mixture of an argon gas and 8 vol% of an oxygen gas under a pressure of 0.53 Pa at a frequency of 50 kHz at an electric power density of 1.5 W/cm² with a reverse pulse duration of 1 µsec to form an adhesion layer 36 having a thickness of 5 nm.

Then, pulse sputtering was carried out by using a graphite target (tradename: IG-51 0U, manufactured by TOYO TANSO CO., LTD.) by introducing a gas mixture of an argon gas and a hydrogen gas under a pressure of 0.20 Pa at a frequency of 100 kHz at an electric power density of 2.5 W/cm² with a reverse pulse duration of 4.5 µsec to form a hydrogenated carbon layer 35 having a thickness of 5 nm. In the gas, the content of the hydrogen gas was 30 vol%.

In such a manner, an electroconductive laminate 30 comprising the high refractive index layers 33a to 33e containing titanium oxide and zinc oxide as the main components and the metal layers 34a to 34d made of a gold/silver alloy alternately laminated on the substrate 31, and further the adhesion layer 36 and the hydrogenated carbon layer 35 laminated in this order on the surface of the high refractive index layer 33e, was obtained.

With respect to the obtained electroconductive laminate, measurement of the hydrogen atom content in the hydrogenated carbon layer, a moist heat resistance test, measurement of the luminous transmittance, measurement of the mechanical durability and measurement of the contact resistance were carried out. The results are shown in Table 1.

### EXAMPLE 2

An electroconductive laminate was prepared in the same manner as in Example 1 except that a hydrogenated carbon layer 35 was not provided, and the thickness of the high refractive index layer 33e most removed from the substrate was changed to 35 nm.

With respect to the obtained electroconductive laminate, measurement of the hydrogen atom content in the hydrogenated carbon layer, a moist heat resistance test, measurement of the luminous transmittance, measurement of the mechanical durability and measurement of the contact resistance were carried out. The results are shown in Table 1.

### EXAMPLE 3

An electroconductive laminate 30 was formed in the same manner as in Example 1 except that the gas introduced at the time of forming the hydrogenated carbon layer 35 was changed to a gas mixture of an argon gas and a hydrogen gas, wherein the hydrogen gas content was 10 vol%.

With respect to the obtained electroconductive laminate, measurement of the hydrogen atoms content in the hydrogenated carbon layer, a moist heat resistance test, measurement of the luminous transmittance, measurement of the mechanical durability and measurement of the contact resistance were carried out. The results are shown in Table 1.

### EXAMPLE 4

An electroconductive laminate was formed in the same manner as in Example 1 except that an adhesion layer 36 was not provided.

With respect to the obtained electroconductive laminate, measurement of the hydrogen atom content in the hydrogenated carbon layer, a moist heat resistance test, measurement of the luminous transmittance, measurement of the mechanical durability and measurement of the contact resistance were carried out. The results are shown in Table 1.

### EXAMPLE 5

An electroconductive laminate 35 was formed in the same manner as in Example 1 except that the method for forming the hydrogenated carbon layer 35 was changed to AC sputtering instead of pulse sputtering. The AC sputtering was carried out by introducing a gas mixture of argon and hydrogen under a pressure of 0.2 Pa at a frequency of 25.0 kHz at an electric power density of 3.94 W/cm² per one cathode to form a hydrogenated carbon layer 35 having a thickness of 5 nm. The content of a hydrogen gas in the gas mixture was 20 vol%.

With respect to the obtained electroconductive laminate, measurement of the hydrogen atom content in the hydrogenated carbon layer, a moist heat resistance test, measurement of the luminous transmittance, measurement of the mechanical durability and measurement of the contact resistance were carried out. The results are shown in Table 1.

### EXAMPLE 6

An electroconductive laminate 35 was formed in the same manner as in Example 1 except that the method for forming the hydrogenated carbon layer 35 was changed to AC sputtering instead of pulse sputtering. The hydrogen AC sputtering was carried out by introducing a gas mixture of argon and hydrogen under a pressure of 0.2 Pa at a frequency of 25.0 kHz at an electric power density of 3.94 W/cm² per one cathode to form a hydrogenated carbon layer 35 having a thickness of 5 nm. The content of a hydrogen gas in the gas mixture was 30 vol%.

With respect to the obtained electroconductive laminate, measurement of the hydrogen atom content in the hydrogenated carbon layer, a moist heat resistance test, measurement of the luminous transmittance, measurement of the mechanical durability and measurement of the contact resistance were carried out. The results are shown in Table 1.

### EXAMPLE 7

An electroconductive laminate 30 was formed in the same manner as in Example 1 except that the method of forming the hydrogenated carbon layer 35 was changed to a magnetron plasma CVD method instead of pulse sputtering. The magnetron plasma CVD method was carried out by using a graphite target (tradename: IG-15, manufactured by TOYO TANSO CO., LTD.) as a cathode, by incorporating a magnetic circuit to the cathode to generate magnetic field lines of 400 G, by using C₂H₄ gas as the source gas, under a pressure of 2 Pa at an electric power of 450 W at a frequency of 13.56 MHz.

With respect to the obtained electroconductive laminate, measurement of the hydrogen atom content in the hydrogenated carbon layer, a moist heat resistance test, measurement of the luminous transmittance, measurement of the mechanical durability and measurement of the contact resistance were carried out. The results are shown in Table 2.

### EXAMPLE 8

An electroconductive laminate 30 was formed in the same manner as in Example 1 except that the method of forming the hydrogenated carbon layer 35 was changed to a LIS-CVD method (source gas: C₂H₄, pressure: 0.08 Pa, power: 120 W) instead of pulse sputtering, and the thickness was changed to 3 nm.

With respect to the obtained electroconductive laminate, measurement of the hydrogen atom content in the hydrogenated carbon layer, a moist heat resistance test, measurement of the luminous transmittance, measurement of the mechanical durability and measurement of the contact resistance were carried out. The results are shown in Table 2.

The electroconductive laminates in Examples 1, 5, 6, 7 and 8 were excellent in all of luminous transmittance, moist heat resistance, mechanical durability and contact resistance. The electroconductive laminate in Example 3 had a hydrogen content of 10.1 at% in the hydrogenated carbon layer, whereby the luminous transmittance was slightly poor, but the moisture resistance, mechanical durability and contact resistance were excellent. In Example 3, the hydrogen atom content in the hydrogenated carbon layer was small at a level of 10.1 at%, whereby the luminous transmittance had a slightly low value of 62.5%, but since the luminous transmittance was at least 60%, the degree of freedom in color compensation can be secured in its application to a filter for a plasma display. With the electroconductive laminates in Examples 1 and 4 to 8, the luminous transmittance exceeded 65%, whereby the degree of freedom in color compensation can further sufficiently be secured. If the hydrogen atom content becomes less than 9%, the luminous transmittance of such an electroconductive laminate tends to be less than 60%, whereby if it is attempted to apply such an electroconductive laminate to a filter for a plasma display, the degree of freedom in color designing will be substantially zero.

The electroconductive laminate in Example 4 had no adhesion layer, whereby peeling was likely to occur at the interface between the high refractive index layer and the hydrogenated carbon layer, and thus its mechanical durability was slightly poor, but the luminous transmittance, moist heat resistance and contact resistance were excellent. The electroconductive laminate in Example 2 had no hydrogenated carbon layer, whereby the results shows that it was inferior in moist heat resistance and mechanical durability.

**TABLE 1**

| Sputtering | H₂ concentration (vol%) | Hydrogen amount in film (at%) | Adhesion layer | Moist heat resistance (number) | Tv (%) | Scratch width (µm) | Contact resistance (Ω) |
|---|---|---|---|---|---|---|---|
| Ex. 1 | 30 | 29.8 | Present | 0 | 68.8 | No scratches | 0.35 |
| Ex. 2 | - | - | Nil | 11 | 70.9 | 31 | 0.20 |
| Ex. 3 | 10 | 10.1 | Present | 0 | 62.5 | No scratches | 0.35 |
| Ex. 4 | 30 | 29.6 | Nil | 0 | 69.6 | 18 | 0.32 |
| Ex. 5 | 20 | 39.2 | Present | 0 | 69.6 | No scratches | 0.32 |
| Ex. 6 | 30 | 43.9 | Present | 0 | 70.8 | No scratches | 0.34 |

**TABLE 2**

| CVD | C₂H₄ concentration (vol%) | Hydrogen amount in film (at%) | Adhesion layer | Moist heat resistance (number) | Tv (%) | Scratch width (µm) | Contact resistance (Ω) |
|---|---|---|---|---|---|---|---|
| Ex. 7 | 100 | 43.7 | Present | 0 | 68.8 | No scratches | 0.34 |
| Ex. 8 | 100 | 25.7 | Present | 0 | 71.6 | No scratches | 0.33 |

Terms in the Tables have the following meanings, respectively.
H₂ concentration: the hydrogen gas content in the gas at the time of forming the hydrogenated carbon layer by sputtering.

Hydrogen amount in film: the content of hydrogen atoms in the hydrogenated carbon layer.

Moist heat resistance: number of defects in the moist heat resistance test.
Tv: luminous transmittance.

Scratch width: the widths of scratch marks measured in the mechanical durability test.

Contact resistance: the contact resistance measured in the contact resistance test.

C₂H₄ concentration: the content of ethylene gas in the source gas at the time of forming the hydrogenated carbon layer by CVD.

### INDUSTRIAL APPLICABILITY

The electroconductive laminate of the present invention is excellent in electrical conductivity (electromagnetic wave shielding properties), visible light transmittance and near infrared shielding properties, and when it is laminated on a supporting substrate, the transmission/reflection band becomes broad, whereby it is useful as an electromagnetic shielding film for PDP or a filter for PDP. Further, the electroconductive laminate of the present invention can be used as a transparent electrode for e.g. a liquid crystal display device, a windshield glass for an automobile, a heat mirror or an electromagnetic wave shielding window glass.

The entire disclosure of Japanese Patent Application No. 2007-242795 filed on September 19, 2007 including specification, claims, drawings and summary is incorporated herein by reference in its entirety.

## Claims

1. An electroconductive laminate comprising a substrate and an electroconductive film formed on the substrate, wherein the electroconductive film has a multilayer structure having a high refractive index layer and a metal layer alternately laminated in this order from the substrate side in a total number of 2n or 2n+1 layers (wherein n is an integer of from 1 to 12) and further having a hydrogenated carbon layer at a position most removed from the substrate; the refractive index of the high refractive index layer is from 1.5 to 2.7; the hydrogenated carbon layer contains carbon atoms and hydrogen atoms; and the content of hydrogen atoms in the hydrogenated carbon layer is from 9 to 50 atomic%.

2. The electroconductive laminate according to Claim 1, wherein an adhesion layer is provided in direct contact with the substrate-side surface of the hydrogenated carbon layer.

3. The electroconductive laminate according to Claim 2, wherein the electroconductive film has a multilayer structure having a high refractive index layer and a metal layer alternately laminated in this order from the substrate side in a total number of 2n+1 layers (wherein n is an integer of from 1 to 12) and further having a hydrogenated carbon layer at a position most removed from the substrate; the high refractive index layer is a layer containing zinc oxide as the main component; and the adhesion layer is a film containing an oxide of Sn.

4. The electroconductive laminate according to Claim 1, 2 or 3, wherein the metal layer is a layer containing silver.

5. The electroconductive laminate according to any one of Claims 1 to 4, wherein the hydrogenated carbon layer has a thickness of from 1 to 60 nm.

6. The electroconductive laminate according to any one of Claims 1 to 5, which has a luminous transmittance of at least 60%.

7. An electromagnetic wave shield for a plasma display, which has the electroconductive laminate as defined in any one of Claims 1 to 6.

8. A filter for a plasma display, which has the electromagnetic wave shield for a plasma display as defined in Claim 7.

9. A process for producing an electroconductive laminate, which comprises a step of laminating, on the surface on one side of a substrate, a high refractive index layer and a metal layer alternately in this order in a total number of 2n or 2n+1 layers (wherein n is an integer of from 1 to 12), and a step of further forming a hydrogenated carbon layer at a position most removed from the substrate, wherein the step of forming a hydrogenated carbon layer is a step of carrying out sputtering by using a graphite target.

10. The process for producing an electroconductive laminate according to Claim 9, wherein the step of carrying out sputtering by using a graphite target is one wherein the sputtering is carried out while a gas containing hydrogen gas is supplied, and the content of hydrogen gas in the gas is from 5 to 60 vol%.

11. A process for producing an electroconductive laminate, which comprises a step of laminating, on the surface on one side of a substrate, a high refractive index layer and a metal layer alternately in this order in a total number of 2n or 2n+1 layers (wherein n is an integer of from 1 to 12), and a step of further forming a hydrogenated carbon layer at a position most removed from the substrate, wherein the step of forming a hydrogenated carbon layer is a step of forming by a chemical vapor deposition method wherein at least one source gas selected from CH₄, C₂H₂ and C₂H₄ is used.
